(19) Europäisches Patentamt
European Patent Office
Office européen des brevets

(11) EP 2 449 585 B1

(12) FASCICULE DE BREVET EUROPEEN

(45) Date de publication et mention de la délivrance du brevet:
**20.08.2014 Bulletin 2014/34**

(21) Numéro de dépôt: **10730434.7**

(22) Date de dépôt: **01.07.2010**

(51) Int Cl.:
***H01L 21/768*** *(2006.01)* ***H01L 21/321*** *(2006.01)*
***H01L 21/3105*** *(2006.01)*

(86) Numéro de dépôt international:
**PCT/EP2010/059336**

(87) Numéro de publication internationale:
**WO 2011/000899 (06.01.2011 Gazette 2011/01)**

(54) **PROCÉDÉ DE MODIFICATION DE LA STRUCTURE CRISTALLINE D'UN ÉLÉMENT EN CUIVRE**

VERFAHREN ZUR MODIFIZIERUNG DER KRISTALLINEN STRUKTUR EINES KUPFERELEMENTS

METHOD FOR MODIFYING THE CRYSTALLINE STRUCTURE OF A COPPER ELEMENT

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **03.07.2009 FR 0954610**

(43) Date de publication de la demande:
**09.05.2012 Bulletin 2012/19**

(73) Titulaires:
- **Commissariat à l'Énergie Atomique et aux Énergies Alternatives 75015 Paris (FR)**
- **STMicroelectronics (Crolles 2) SAS 38920 Crolles (FR)**

(72) Inventeurs:
- **DI CIOCCIO, Léa F-38330 Saint Ismier (FR)**
- **GUEGUEN, Pierric F-38130 Echirolles (FR)**
- **RIVOIRE, Maurice F-38240 Meylan (FR)**

(74) Mandataire: **Ilgart, Jean-Christophe et al BREVALEX 95, rue d'Amsterdam 75378 Paris Cedex 8 (FR)**

(56) Documents cités:
**WO-A1-2007/020939**
**US-A1- 2005 003 650**
**US-A1- 2007 238 294**
**US-A1- 2009 035 936**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 449 585 B1

## Description

### DOMAINE TECHNIQUE ET ART ANTÉRIEUR

La présente invention se rapporte à un procédé de modification de la structure cristalline d'éléments en cuivre, et plus particulièrement de connexions en cuivre mises en oeuvre dans les dispositifs microélectroniques

Le cuivre présente une très bonne conductivité électrique et est donc couramment utilisé pour réaliser des connexions dans les dispositifs microélectroniques.

La conductivité électrique dépend, entre autres, de la cristallographie de la connexion, plus particulièrement de l'orientation des plans denses par rapport à la direction de circulation du courant. En effet, la conduction dans une direction perpendiculaire aux plans denses est bien moindre que celle dans la direction des plans. En outre, la présence de joints de grain provoque une élévation de la résistivité, il est donc préférable de réduire leur nombre, en réalisant des lignes de connexion à gros grains.

Or il est relativement difficile de réaliser directement des lignes de contact monocristallines ou avec des gros grains du fait de leur taille réduite. De même l'obtention d'une orientation donnée des plans denses dans une connexion électrique directement lors du dépôt est complexe.

Une technique connue pour augmenter la taille des grains est d'effectuer un recuit à une température porche de la température de fusion. Dans le cas du cuivre, le recuit devrait se faire à une température de l'ordre de 900°C. Or, dans le cas particulier des structures microélectroniques, cette température ne peut dépasser 400°C afin de préserver la structure microélectronique. Le recuit doit alors avoir une durée importante. C'est par conséquent un but de la présente invention d'offrir un procédé permettant de modifier les caractéristiques cristallographiques d'éléments de connexion en cuivre, en particulier du type de ceux mis en oeuvre dans les dispositifs microélectroniques.

### EXPOSÉ DE L'INVENTION

Le but précédemment énoncé est atteint par un procédé de modification de la structure cristalline destiné à modifier la structure cristalline d'un élément en cuivre après sa réalisation, par mise en contact de l'élément à modifier avec un élément en cuivre présentant les caractéristiques cristallographiques souhaitées.

La mise en contact est de type adhérent, désigné également par collage direct ou collage moléculaire.

En effet, les inventeurs se sont aperçus que la simple mise en contact de deux éléments en cuivre présentant un certain état de surface permettait de transmettre la structure cristallographique d'un élément à un autre.

Le document US2009/0035936 décrit une technique pour orienter les grains dans une couche de métallisation. De ce document une couche de germe avec une orientation souhaitée est déposée sur l'élément en cuivre et enlevée par polissage après la transmission de l'orientation souhaitée par un recuit.

On utilise alors des éléments monocristallins de grande taille, plus facilement réalisables, que l'on met en contact avec l'élément déjà réalisé dont on souhaite modifier la structure.

Le procédé selon la présente invention permet alors de transformer une ligne polycristalline en une ligne monocristalline. Il permet également d'imposer une orientation donnée aux plans denses.

La présente invention a alors principalement pour objet un procédé de modification de la structure cristalline d'un élément en cuivre présentant des grains d'une première taille muni d'une face plane, comportant :

a) une étape de réalisation d'un étalon en cuivre présentant des grains d'une seconde taille supérieure à la première taille, ledit étalon comportant une face plane,
b) une étape de réduction de la rugosité des faces planes à une rugosité inférieure à 1 nm RMS, avantageusement inférieure ou égale à 0,5 nm.
c) une étape de nettoyage des dites faces planes,
d) une étape de mise en contact des deux faces planes,
e) une étape de recuit à une température inférieure à 400°C, la structure cristallographique de l'étalon en cuivre étant alors transmise à l'élément en cuivre.

Le procédé peut comporter une étape supplémentaire f) de séparation de l'étalon et de l'élément.

Par exemple, l'élément comporte au moins une interconnexion de petite surface formée de grains d'une première taille, dans lequel lors de l'étape a) on réalise un étalon muni d'au moins une ligne de grande surface avec au moins un grain de la deuxième taille, la surface de la ligne de grande surface étant supérieure à celle de l'interconnexion de petite surface de l'élément à restaurer, et lors de l'étape d) l'interconnexion de petite surface étant mise en contact avec le plot de grande surface.

L'étalon peut comporter au moins un grain dont la surface est au moins égal à celle de l'interconnexion de petite surface, et dans lequel lors de l'étape d), l'interconnexion de petite surface est alignée avec ledit grain de la ligne

de grande surface.

L'élément peut également comporter une interconnexion d'axe longitudinal et l'étalon peut être formé d'un monocristal, lors de la mise en contact de l'élément avec l'étalon, l'étalon est orienté de sorte que les plans denses soient parallèles à l'axe de l'interconnexion.

Le procédé selon l'invention peut comporter une étape d'application d'un effort sur l'un des éléments tendant à rapprocher les faces lors de l'étape de mis en contact.

L'étape b) de réduction de la rugosité est obtenue par exemple un polissage mécano-chimique.

L'étape f) est par exemple obtenue par planarisation mécano-chimique, par polissage, par dissolution chimique, par abrasion ou par découpe. Dans ce dernier cas l'étalon peut être réutilisé.

La température de recuit est par exemple comprise entre 200°C et 400°C.

## BRÈVE DESCRIPTION DES DESSINS

La présente invention sera mieux comprise à l'aide de la description qui va suivre et des dessins en annexes sur lesquels :

- les figures 1A et 1B sont des représentations schématiques d'étapes d'un procédé selon l'invention illustrant la modification de la structure cristalline d'un élément en cuivre par un autre,
- les figures 2A et 2B sont des représentations schématiques d'étapes d'un procédé de modification de la structure cristalline de lignes de petite taille selon la présente invention,
- la figure 3 est une représentation schématique d'une interconnexion de cuivre dont on souhaite modifier l'orientation des plans denses par le procédé selon la présente invention.

## EXPOSÉ DÉTAILLÉ DE MODES DE RÉALISATION PARTICULIERS

Selon la présente invention, on souhaite modifier la structure cristalline d'un élément en cuivre qui initialement présente des petits grains, un élément en cuivre présentant plusieurs gros grains, voire un seul gros grain.

On entend par élément en cuivre dans la présente invention, une ligne de cuivre servant d'interconnexion dans un plan, un via servant d'interconnexion entre les plans ou un plot de contact ou tout élément en cuivre formant une connexion électrique au sein d'une structure microélectronique.

Selon la présente invention, on utilise un élément présentant de gros grains tels que ceux que l'on souhaite obtenir pour l'élément. Cet élément sert donc d'étalon dont on souhaite reproduire la structure cristallographique.

L'élément en cuivre dont on veut modifier la structure cristalline comporte initialement des grains d'une première taille et l'étalon comporte au moins un grain d'une seconde taille supérieure à la première taille. Les grains de l'élément dont on souhaite modifier la structure cristalline ne sont bien entendu pas nécessairement tous de la même taille, ni ceux de l'étalon. A des fins de simplicité cependant, nous considérons "une première taille" et "une deuxième taille". Les grains d'une première taille seront désignés par "petits grains" et les grains de la deuxième taille seront désignés par "gros grains" En outre l'étalon peut comporter un ou plusieurs grains, et l'élément dont on souhaite modifier la structure cristalline, après mise en oeuvre du procédé de modification de la structure cristalline, peut présenter un ou plusieurs grains.

Les figures 1A et 1B représentent des étapes d'un procédé de modification de la structure cristalline d'un élément en cuivre selon la présente invention.

On souhaite obtenir à partir d'un élément en cuivre II présentant des petits grains 24, un élément en cuivre présentant plusieurs gros grains, voire un seul gros grain.

Selon la présente invention, on utilise un élément I présentant de gros grains 22 tels que ceux que l'on souhaite obtenir pour l'élément II. L'élément I sert donc d'étalon dont on souhaite reproduire la structure cristallographique.

L'étalon I peut être une plaque monocristalline obtenue directement par tirage de lingot ou une plaque avec des gros grains obtenus en effectuant un recuit très long. On peut également générer des défauts volontairement, par exemple des dislocations et effectuer un recuit à une température légèrement inférieure à la température de fusion.

L'étalon I peut également être une couche de cuivre monocristallin ou à gros grains déposée sur un substrat. Par exemple, on peut utiliser une couche de cuivre à gros grain de l'ordre de 500 nm d'épaisseur, dans ce cas les grains ont un diamètre de l'ordre 500 nm.

L'étalon I peut aussi être une lamelle de cuivre monocristallin.

L'étalon I et l'élément II présentent chacun une face plane 2, 4 respectivement, par lesquelles les deux éléments vont être mis en contact.

Lors d'une première étape, les faces 2, 4 sont polies pour assurer un très bon contact entre les deux faces 2, 4. Par exemple, les deux surface subissent une planarisation mécano-chimique afin d'atteindre une très faible rugosité comprise entre 0 et 1 nm RMS (Root Mean Square value), et avantageusement inférieure ou égale à 0,5 nm.

Lors d'une étape suivante, les deux faces 2, 4 sont nettoyées pour supprimer la présence de particules dues au polissage.

Lors d'une étape suivante, les deux faces 2, 4 sont mises en contact (figure 1A) à pression atmosphérique et à température ambiante. Les étapes de planarisation et de nettoyage permettent alors d'obtenir un contact moléculaire ou collage direct entre les deux éléments.

L'étalon I et l'élément II subissent ensuite une étape de recuit. Il n'est pas nécessaire de prévoir des conditions de pression particulière, le recuit peut avoir lieu à pression atmosphérique.

L'élément II voit alors sa structure cristalline se modifier, les petits grains disparaissent pour former des gros grains, qui sont le prolongement des gros grains de l'étalon I.

L'étape de recuit peut avoir lieu avec ou sans application d'un effort de pression sur l'un des éléments rapprochant les deux faces 2, 4.

On obtient donc un élément II présentant des gros grains dans une orientation identique à celle de l'étalon I. L'étalon I peut ensuite être retiré par divers techniques, comme par exemple par planarisation mécano-chimique (CMP), polissage, par dissolution chimique ou par abrasion.

Il est également envisageable de désolidariser l'étalon I de l'élément II pour pouvoir le réutiliser, par exemple en découpant l'interface au moyen d'une lame diamant. Par exemple, dans le cas d'une surface comportant des lignes de cuivre séparées par des zones d'oxyde, les lignes de cuivres font saillie des zones d'oxyde, le collage a alors lieu principalement au niveau des lignes, la découpe se fait alors au niveau de ces lignes.

L'assemblage formé par l'étalon I et l'élément II après recuit présente les propriétés d'un seul élément monobloc de cuivre, l'interface de contact ayant disparue lors du recuit, cet assemblage peut alors être utilisé en tant que tel.

Sur les figures 2A et 2B, on peut voir des étapes d'un procédé de modification de la structure cristalline selon la présente invention permettant de réaliser des lignes de petite taille monocristallines.

Un élément II' présente une surface plane 16 muni d'au moins une ligne de petite taille 10 avec de petits grains 12, que l'on souhaite modifier en une ligne monocristalline.

Selon la présente invention, on utilise un étalon I" présentant une ligne de grande taille 6 avec des gros grains 8. Plus particulièrement, dans l'exemple représenté, la ligne de grande taille 6 présente au moins un gros grain dont la surface 14 est plus grande que celle 16 de la ligne de petite taille 10, de sorte que la surface de la ligne de petite taille 10 soit entièrement en contact avec la surface 14 du gros grain.

La ligne de grande taille munie de gros grains de l'étalon I' peut être obtenue par exemple par un recuit de très longue durée.

La surface de l'étalon I' et la surface 16 du deuxième élément II" subissent une étape de planarisation de sorte à atteindre une très faible rugosité, inférieure à 1 nm et avantageusement inférieure ou égale à 0,5 nm RMS, et une étape de nettoyage.

L'étalon I' et l'élément II" sont ensuite mis en contact par les surfaces 14 et 16. On aligne le gros grain de la ligne de grande taille 6 avec la ligne de petite taille 10. Un collage direct entre les deux surfaces a lieu.

On applique ensuite un recuit, avec ou sans application de pression, ce qui provoque une modification de la structure cristalline de la ligne de petite taille 10. Les grains de petites tailles grossissent pour ne former que quelques grains de grandes tailles, voire un seul grain de grande taille. Dans l'exemple représenté, la ligne 10 présente un seul grain 18. On peut prévoir une étape de retrait du premier élément I". Le premier élément I" sert uniquement à provoquer la formation d'une ligne de petite taille 10 monocristalline.

Dans l'exemple représenté et de manière avantageuse, la ligne de grande taille 6 présente des grains de taille supérieure à la taille de la ligne de petit taille 10. Ainsi, lors de la modification de la structure cristalline, la ligne de petite taille 10 sera formée d'un seul grain, elle sera donc monocristalline. Dans ce cas, lors de la mise en contact, on aligne la ligne de petite taille 10 avec un seul grain de la ligne de grande taille 6. De manière avantageuse, on prévoit d'utiliser des lignes de grande taille monocristallines. Mais il est bien entendu que l'n peut également prévoir de restaurer la ligne de petite taille de sorte qu'elle présente non pas un seul grain, mais plusieurs gros grains.

Ce procédé est particulièrement intéressant puisqu'il est particulièrement difficile de réaliser directement des lignes de petites tailles monocristallines. Ainsi on réalise une ligne de grande taille avec de gros grains que l'on « reporte » sur une ligne de petite taille avec de petits grains.

Par ailleurs, le fait d'utiliser un étalon comportant une ligne de grande taille et non une plaque entière pour restaurer les lignes de petites taille présente l'avantage d'éviter une mise en contact de toute la surface du composant microélectronique avec le cuivre, la surface de contact se limite à celle de la ligne de grande taille. Par ailleurs, cette technique permet d'avoir un procédé entièrement microélectronique dans la réalisation de l'élément microélectronique et de l'étalon I'. Par ailleurs, le retrait de l'étalon I' est plus facile. En effet le silicium formant le substrat est retiré facilement par une attaque chimique, puis on retire l'oxyde et la ligne de grande taille par CMP (polissage mécano-chimique).

Il est bien entendu que l'on peut restaurer plusieurs lignes 10 d'un élément II' simultanément, il suffit de mettre en contact la face plane des lignes 10 avec l'étalon. Si l'on souhaite des lignes monocristallines, on aligne chaque ligne avec un grain de l'étalon.

Le retrait du premier élément peut être obtenu selon divers techniques, par exemple par planarisation mécano-chimique (CMP), polissage, par dissolution chimique ou par abrasion, ou par découpe comme décrit ci-dessus.

Les lignes de grande taille peut avoir une taille supérieure ou égale à une dizaine de nm.

La température du recuit de modification de la structure cristalline est fonction du substrat processé sur lequel les lignes de cuivre sont réalisées, la température de recuit est comprise entre 200°C et 400°C. La durée du recuit est fonction de la température de recuit, plus la température est élevée, plus le durée du recuit peut être réduite.

Comme cela a été expliqué précédemment, le procédé de modification de la structure cristalline selon la présente invention permet de réorienter les grains dans une direction donnée de manière simple. Elle permet également d'orienter les plans denses des grains selon une direction donnée.

Cette orientation des plans denses est particulièrement intéressante pour la circulation du courant dans une interconnexion, qui s'effectue dans la direction de l'axe de l'interconnexion. En effet, la conductivité électrique dans la direction des plans denses est supérieure à celle dans une direction sécante aux plans denses.

Dans le cas d'une interconnexion linéaire 22 d'axe longitudinal X s'étendant entre deux contacts 24, telle que représentée sur la figure 3, on souhaite avoir des plans denses orientés sensiblement parallèlement à l'axe longitudinal X. Or, dans le cas d'éléments de taille si petite, il est très difficile de réussir un dépôt monocristallin dont les plans denses soient directement orientés de la manière souhaitée.

Selon le procédé de la présente invention, on réalise un étalon monocristallin muni d'une face destinée à venir en contact avec la face libre de l'interconnexion, et dont les plans denses du monocristal sont orientés parallèlement à l'axe longitudinal X de l'interconnexion.

L'orientation des plans denses dans l'étalon est obtenue par la maîtrise lors de la croissance du monocristal.

La face libre de l'interconnexion et la face de l'étalon subissent un polissage tel que décrit précédemment pour atteindre une rugosité très faible comprise entre 0 et 1 nm RMS, et avantageusement inférieure ou égale à 0,5 nm RMS et une étape de nettoyage.

Les deux faces sont ensuite mises en contact et subissent un recuit.

Nous allons maintenant donner un exemple de polissage, mais celui-ci n'est en aucun limitatif et tout autre procédé permettant d'atteindre une rugosité inférieure à 1 nm est utilisable.

Les plots de contact ou des interconnexions son réalisés par des techniques classiques de microélectroniques de dépôt et de gravure, celles-ci étant bien connues de l'homme du métier, elles ne seront pas décrites davantage.

On effectue un polissage mécano-chimique ou CMP (« Chemical Mechanical Polishing » en anglais), pour aplanir les faces destinées à venir en contact.

Les faces à polir sont frottées sur un tissu appelé "pad" composé de polyuréthane poreux viscoélastique et dont les propriétés (dureté, compressibilité, forme et dimension des pores et des motifs...) dépendent de la nature du matériau à polir. Le ou les matériaux des faces est (sont) arraché(s) par réaction chimique et action mécanique à l'aide du tissu et/ou d'une solution de polissage contenant des particules appelée également "slurry" (particules en suspension dans une solution chimique acide ou basique). Ces slurries peuvent être composés de particules de tailles nanométriques dans une solution liquide (solution colloïdale, micelles, Langmuir-Blodget, etc.).

Le polissage est obtenu par la combinaison de plusieurs actions :

- une action mécanique obtenue par le frottement du tissu et/ou des particules du slurry sur la surface. La vitesse d'enlèvement du matériau a été modélisée par Preston selon l'équation suivante :

$$RR = K_p * P * V \quad [1]$$

avec :

RR (Removal Rate) : taux d'enlèvement en un point donné (en nm/min),

$K_p$ = Constante de Preston prenant en compte les caractéristiques du matériau, du tissu, du type d'abrasif, de la température...

P = Pression appliquée (en Newton),

V = Vitesse linéaire d'un point de la plaque par rapport au tissu (en m/s),

-une action chimique ; lors du polissage, on souhaite à la fois polir du cuivre et le matériau diélectrique. Les slurries sont donc adaptés pour avoir une action chimique sur le cuivre et sur le matériau diélectrique. Concernant le cuivre, l'action chimique provient généralement d'une attaque par un acide et/ou d'un oxydant permettant de réagir avec la surface à polir.

Généralement, un slurry est constitué par la présence d'agent chimique d'attaque des métaux, d'un oxydant

(généralement $H_2O_2$), d'un agent stabilisateur du pH ajouté à la solution acide ou basique du slurry et d'un inhibiteur de corrosion. La solution chimique va passiver (K1) le matériau en formant à sa surface un oxyde métallique qui sera enlevé mécaniquement (K2) par le tissu et par les éventuelles particules du slurry. La solution chimique va alors formée du $CuO_x$.

$$Cu + OX \xrightarrow{k_1} CuOX^* \xrightarrow{k_2} CuOX$$

Cette réaction chimique facilite et accélère le mécanisme de polissage. D'autres réactions chimiques peuvent être engendrées par la formation de cations métalliques cuivre/cuivre$^+$ ou cuivre/$Cu^{2+}$ solubles et retirés de la surface à polir par le tissu et ou les particules du slurry.

Pour le matériau diélectrique, les slurries utilisés généralement sont des solutions aqueuses. L'eau a une grande importance pour le polissage de diélectrique, par exemple d'un oxyde de silicium. Deux réactions chimiques interviennent.

Tout d'abord, l'eau pénètre sous l'effet de la pression et casse certaines liaisons Si - O de l'oxyde de silicium pour former une surface hydratée. La séparation des liaisons (Si-O-Si) est contrôlée par la diffusion de l'eau dans la silice. Le polissage se réalise lorsque la réaction d'hydratation réversible (polymérisation) suivante :

$$(SiO_2)_x + 2H_2O \leftrightarrow (SiO_2)_{x-1} + Si(OH)_4$$

peut se produire dans le sens inverse, c'est-à-dire dans de le sens de l'hydratation (dépolymérisation), comme cela est décrit notamment dans l'ouvrage Handbook of Semiconductor Interconnection Technology par GC Schwarz.

Le mouvement du tissu par rapport à la plaque de silicium permet alors d'arracher les particules de slurry de la surface emportant ainsi des atomes du matériau superficiel.

Afin d'effectuer une attaque chimique à la fois du cuivre et du matériau diélectrique, on peut utiliser une solution aqueuse obtenue par solubilisation dans de l'eau désionisée :

- d'un ou deux agents complexant ou d'attaque chimique des métaux et des éventuels composés métalliques (glycine, NH3, EDTA, etc.) qui permet d'augmenter la vitesse de polissage du cuivre,
- d'un inhibiteur de corrosion du cuivre (benzotriazole BTA, triazole TA...), agent passivant le film de cuivre réduit la vitesse de polissage spécifiquement dans les zones basses à aplanir. Souvent deux inhibiteurs sont utilisés,
- d'un surfactant pour stabiliser le pH, améliorer la sélectivité de polissage du cuivre vis-à-vis des autres matériaux utilisés....
- d'un agent oxydant ($H_2O_2$, $KIO_3$, hydroxylamine, etc....) qui suivant le pH et/ou sa concentration peut former soit une passivation du cuivre par un oxyde ou hydroxyde de cuivre insoluble, soit une corrosion par un cation métallique soluble dans la solution aqueuse,
- de particules colloïdales anionique ou cationique, présentant un pH compris entre 1 et 12 sont avantageusement ajoutées pour obtenir une suspension stable de particules. Les particules peuvent être pures comme la silice, du carbone, l'oxyde de cérium, l'alumine ou des polymères. Les tailles des particules élémentaires seront déterminées par la méthode de mise en solution choisie. Elles pourront variées de 3nm à 300nm. Le pourcentage massique de particules dans la solution aqueuse pourra être compris entre quelques ppm et 50 %.

A titre d'exemple, les solutions aqueuses suivantes peuvent être utilisées :

- Klebosol CuS1351® vendue par la société Rohm & Haas : 12 % massique de particules de silice de diamètre de 70nm, de pH10, anionique, ou
- T605® vendu par la société Hitachi Chemical : 0,1 % massique de particules de silice de diamètre 90 nm, de pH 6,5 anionique.

Les caractéristiques des tissus de polissage utilisés dépendent notamment des dimensions des cavités creusées dans un matériau isolant et remplies de cuivre avec ou sans barrière de diffusion ou couche d'adhésion.

Pour des cavités d'une largeur supérieure à 10 $\mu$m, on choisit des tissus dits d'aplanissements en polyuréthane avec une dureté classée en « shore D » de 50 à 70, d'une densité de 60 à 90 mg/cm$^3$, et d'une compressibilité inférieure à 4 %, par exemple le IC1000 de la société Rohm & Haas.

Pour des cavités inférieures à 10 $\mu$m, on choisit des tissus dits médiums, avec une dureté classée en « shore A » de 50 à 70, d'une densité de 20 à 40 mg/cm$^3$, et d'une compressibilité entre 10 et 25 %. Pour cette application, par

exemple le Suba IV de la société Rohm & Haas.

Pour des cavités de l'ordre du micromètre, certains matériaux ductiles risquant d'être rayés par les particules, des tissus de polissage dits de finitions sont préférés, avec une dureté classée en « shore A » de 50 à 80, d'une densité de <20 $mg/cm^3$, et d'une compressibilité >30 %, par exemple le POLITEX® de la société Rohm & Haas, ou des tissus de la marque Fujibo®.

Les éléments sont par exemple traités sur des polisseuses classiques par exemples de types Mirra ou Reflexion de Applied Materials USA, Megapol M550 de Alpsitec France ou FREX de Ebara Japon.

Les paramètres de polissage sont la pression d'appui exercée sur le substrat comprise entre 0,02 $daN/cm^2$ à 1 $daN/cm^2$, la vitesse d'un point du substrat par rapport à un point du tissu est comprise entre 0,1 m/s à 3 m/s, le débit de la solution aqueuse entre 5 et 300ml pour des substrats variant de 1 à 450 mm, la température étant comprise entre 2 et 70°C. Préférentiellement les conditions pour les applications précitées sont de 0,1 $daN/cm^2$, avec une vitesse de 1 m/s, un débit de solution aqueuse de 150ml pour des substrats de 200mm à une température de 52°C.

Le procédé selon la présente invention permet donc de réaliser, notamment, la modification de la structure cristalline d'éléments en cuivre de petites dimensions, avantageusement pour obtenir des éléments monocristallins qui sont difficiles à obtenir directement lors du dépôt. La modification de la structure cristalline selon la présente invention permet également d'orienter les plans denses dans une direction donnée de sorte à améliorer la conductivité électrique.

Le procédé selon la présente invention s'applique tout particulièrement aux éléments des dispositifs microélectroniques, tels que par exemple les plots de contacts, les lignes d'interconnexions ou des vias.

## Revendications

1. Procédé de modification de la structure cristalline d'un élément en cuivre (II, II') muni d'une face plane (4, 16), ledit élément en cuivre présentant des grains d'une première taille comportant :

   a) une étape de réalisation d'un étalon (I ; I') en cuivre présentant au moins un grain d'une seconde taille supérieure à la première taille, ledit étalon comportant une face plane (2, 14),
   b) une étape de réduction de la rugosité des faces planes (2, 14, 4, 16) à une rugosité inférieure à 1 nm RMS.
   c) une étape de nettoyage des dites faces planes (2, 14, 4, 16),
   d) une étape de mise en contact des deux faces planes (2, 14, 4, 16),
   e) une étape de recuit à une température inférieure à 400°C, la structure cristallographique de l'étalon en cuivre étant alors transmise à l'élément en cuivre.

2. Procédé de modification de la structure cristalline selon la revendication 1, dans lequel la rugosité est inférieure ou égale à 0,5 nm.

3. Procédé de modification de la structure cristalline selon la revendication 1 ou 2, comportant une étape supplémentaire f) de séparation de l'étalon (I, I') et de l'élément (II, II').

4. Procédé de modification de la structure cristalline selon l'une des revendications 1 à 3, dans lequel l'élément (II') comporte au moins une interconnexion de petite surface (10) formée de grains (12) d'une première taille, dans lequel lors de l'étape a) on réalise un étalon (I') muni d'au moins une ligne de grande surface (6) avec au moins un grain d'une deuxième taille (8), la surface de la ligne de grande surface (6) étant supérieure à celle de l'interconnexion de petite surface (10) de l'élément à restaurer, et lors de l'étape d) l'interconnexion de petite surface (10) étant mise en contact avec le plot de grande surface.

5. Procédé de modification de la structure cristalline selon la revendication 4, dans lequel l'étalon (I') comporte au moins un grain dont la surface est au moins égale à celle de l'interconnexion de petite surface (10), et dans lequel lors de l'étape d), l'interconnexion de petite surface (10) est alignée avec ledit grain de la ligne de grande surface.

6. Procédé de modification de la structure cristalline selon l'une des revendications 1 à 5, dans lequel l'élément comporte une interconnexion (22) d'axe longitudinal (X) et l'étalon est formé d'un monocristal, lors de la mise en contact de l'élément avec l'étalon, l'étalon est orienté de sorte que les plans denses soient parallèles à l'axe de l'interconnexion (22).

7. Procédé de modification de la structure cristalline selon l'une des revendications 1 à 6, comportant une étape d'application d'un effort sur l'un des éléments tendant à rapprocher les faces lors de l'étape de mise en contact.

**8.** Procédé de modification de la structure cristalline selon l'une des revendications 1 à 7, dans lequel l'étape b) de réduction de la rugosité est effectuée polissage mécano-chimique.

**9.** Procédé de modification de la structure cristalline selon l'une des revendications précédentes prise en combinaison avec la revendication 3, dans lequel l'étape f) est obtenue par planarisation mécano-chimique, par polissage, par dissolution chimique, par abrasion ou par découpe.

**10.** Procédé de modification de la structure cristalline selon l'une des revendications 1 à 9, dans lequel la température de recuit est comprise entre 200°C et 400°C.

**Patentansprüche**

**1.** Verfahren zur Modifizierung der kristallinen Struktur eines Elements aus Kupfer (II, II'), welches eine ebene Seite (4, 16) aufweist, wobei das Kupferelement Körner einer ersten Größe aufweist und das Verfahren die folgenden Schritte umfasst:

a) einen Schritt der Realisation eines Kupfer-Eichmaßes (I; I'), welches zumindest eine zweite Korngröße größer als die erste Korngröße aufweist, wobei das Eichmaß eine ebene Seite (2, 14) aufweist:
b) einen Schritt der Verringerung der Rauhigkeit der ebenen Seiten (2, 14, 4, 16) auf eine Rauhigkeit geringer als 1 nm RMS;
c) einen Schritt der Reinigung der ebenen Seiten (2, 14, 4, 16);
d) einen Schritt der Inkontaktbringung der beiden ebenen Seiten (2, 14, 4, 16);
e) einen Schritt des Glühens bei einer Temperatur niedriger als 400°C, wobei die kristallographische Struktur des Kupfer-Eichmaßes dann an das Kupferelement abgegeben wird.

**2.** Verfahren zur Modifizierung der kristallinen Struktur nach Anspruch 1, bei welchem die Rauigkeit kleiner oder gleich 0,5 nm ist.

**3.** Verfahren zur Modifizierung der kristallinen Struktur nach Anspruch 1 oder 2, welches den zusätzlichen Schritt f) der Trennung des Eichmaßes (I, I') und des Elements (II, II') aufweist.

**4.** Verfahren zur Modifizierung der kristallinen Struktur nach einem der Ansprüche 1 bis 3, in welchem das Element (II') mindestens eine kleinflächige Verbindung (10) aufweist, welche aus Körnern (12) einer ersten Größe gebildet ist, und in welchem in Schritt a) ein Eichmaß (I') realisiert wird, welches mit mindestens einer großflächigen Leitung (6) mit zumindest einem Korn zweiter Größe (8) versehen ist, wobei die Oberfläche der großflächigen Leitung (6) größer ist als die der kleinflächigen Verbindung (10) des zu restaurierenden Elements, und wobei in Schritt d) die kleinflächige Verbindung (10) mit der großflächigen Kontaktstelle in Kontakt gebracht wird.

**5.** Verfahren zur Modifizierung der kristallinen Struktur nach Anspruch 4, bei welchem das Eichmaß (I') zumindest ein Korn aufweist, deren Oberfläche zumindest gleich der Oberfläche der kleinflächigen Verbindung (10) ist, und bei welchem in Schritt d) die kleinflächige Verbindung (10) mit dem Korn der großflächigen Leitung fluchtet.

**6.** Verfahren zur Modifizierung der kristallinen Struktur nach einem der Ansprüche 1 bis 5, in welchem das Element eine Verbindung (22) entlang der Längsachse (X) aufweist, und das Eichmaß aus einem Monokristall gebildet ist, wobei während der Inkontaktbringung des Elements mit dem Eichmaß das Eichmaß derart ausgerichtet ist, dass die dichten Ebenen parallel zur Achse der Verbindung (22) sind.

**7.** Verfahren zur Modifizierung der kristallinen Struktur nach einem der Ansprüche 1 bis 6, welches einen Schritt der Kraftaufbringung auf eines der Elemente zur Annäherung der Flächen während des Schritts der Inkontaktbringung aufweist.

**8.** Verfahren zur Modifizierung der kristallinen Struktur nach einem der Ansprüche 1 bis 7, in welchem in dem Schritt b) die Verringerung der Rauhigkeit durch chemisch-mechanisches Polieren vorgenommen wird.

**9.** Verfahren zur Modifizierung der kristallinen Struktur nach einem der vorhergehenden Ansprüche in Kombination mit Anspruch 3, in welchem der Schritt f) durch chemisch-mechanische Planarisierung, durch Polieren, durch chemische Auflösung, durch Abrieb oder durch Zuschneiden erhalten wird.

**10.** Verfahren zur Modifizierung der kristallinen Struktur nach einem der Ansprüche 1 bis 9, in welchem die Glühtemperatur zwischen 200°C und 400°C liegt.

## Claims

**1.** A method for modifying the crystalline structure of a copper element (II, II') with a planar surface (4, 16), where the said copper element has grains of a first size including:

a) a step of production of a copper standard (I;I') having at least one grain of a second size greater than the first size, where the said standard has a planar surface (2, 14),
b) a step of reduction of the roughness of the planar surfaces (2, 14, 4, 16) to a roughness of less than 1 nm RMS.
c) a step of cleaning the said planar surfaces (2, 14, 4, 16),
d) a step of bringing the two planar surfaces (2, 14, 4, 16) into contact,
e) a step of annealing at a temperature lower than 400°C, the crystallographic structure of the copper standard being transferred to the copper element.

**2.** A method for modifying the crystalline structure according to claim 1, in which the roughness is less than or equal to 0.5 nm.

**3.** A method for modifying the crystalline structure according to claim 1 or 2, including an additional step f) of separation of the standard (I, I') and the element (II, II').

**4.** A method for modifying the crystalline structure according to one of the claims 1 to 3, in which the element (II') includes at least one interconnection of small area (10) formed from grains (12) of a first size, in which during step a) a standard (I') is produced having at least one line of large area (6) with at least one grain of a second size (8), where the area of the line of large area (6) is greater than that of the interconnection of small area (10) of the element to be restored, and where during step d) the interconnection of small area (10) is brought into contact with the pad of large area.

**5.** A method for modifying the crystalline structure according to claim 4, in which the standard (I') includes at least one grain the area of which is at least equal to that of the interconnection of small area (10), and in which, during step d), the interconnection of small area (10) is orientated with the said grain of the line of large area.

**6.** A method for modifying the crystalline structure according to one of the claims 1 to 5, in which the element includes an interconnection (22) of lengthways axis (X) and the standard is formed from a monocrystal, when the element is brought into contact with the standard, the standard is orientated such that the dense planes are parallel to the axis of the interconnection (22).

**7.** A method for modifying the crystalline structure according to one of the claims 1 to 6, including a step of application of a force to one of the elements having the effect of bringing the surfaces close to one another during the contact step.

**8.** A method for modifying the crystalline structure according to one of the claims 1 to 7, in which step b) of reduction of roughness is undertaken by mechano-chemical polishing.

**9.** A method for modifying the crystalline structure according to one of the previous claims, used in combination with claim 3), in which step f) is obtained by mechano-chemical planarisation, by polishing, chemical dissolution, abrasion or cutting.

**10.** A method for modifying the crystalline structure according to one of the claims 1 to 9, in which the annealing temperature is between 200°C and 400°C.

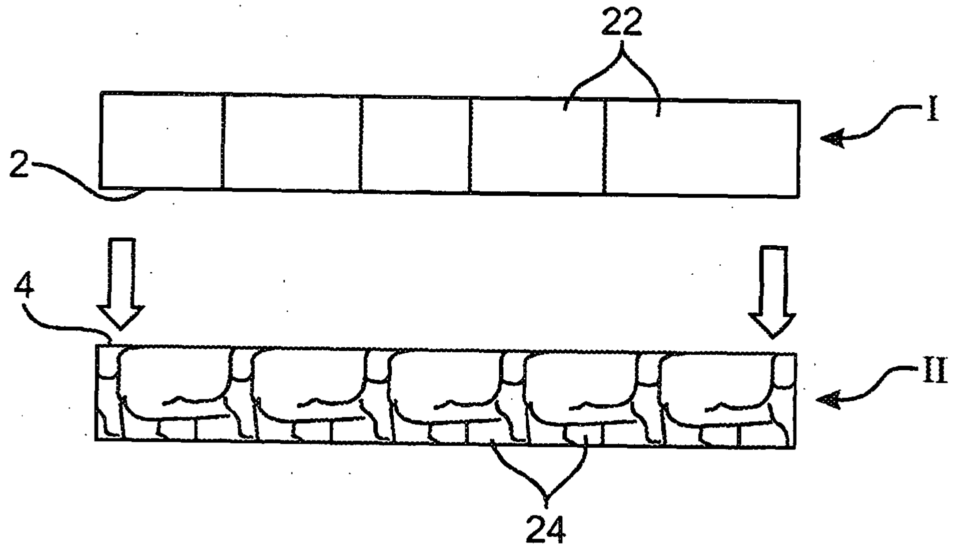


FIG.1A

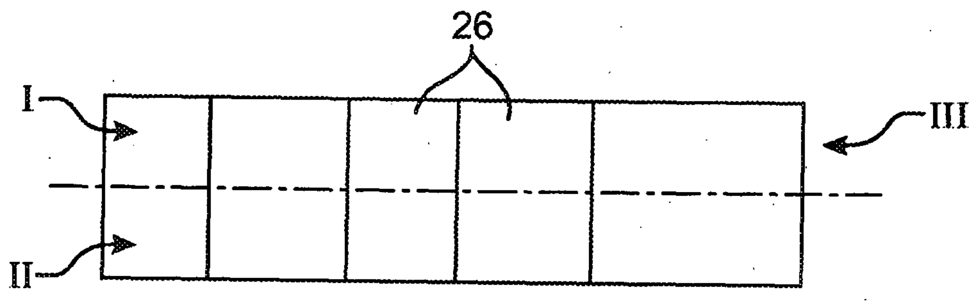


FIG.1B

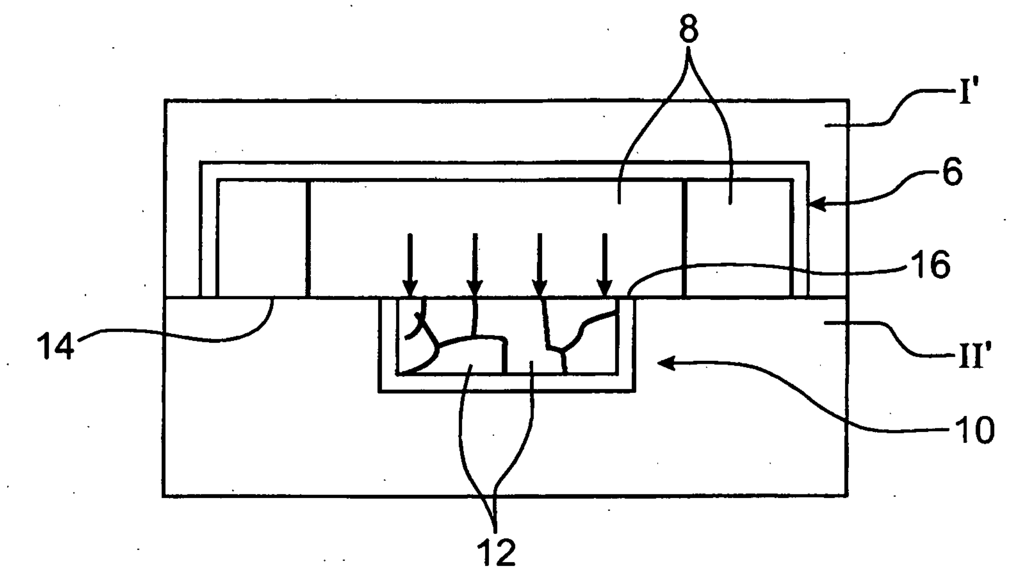


FIG.2A

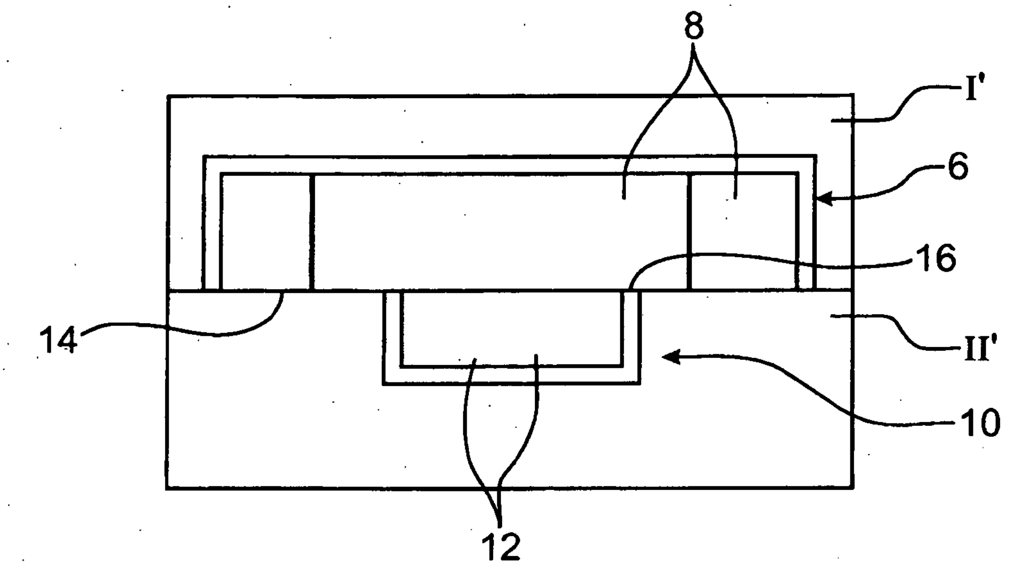


FIG.2B

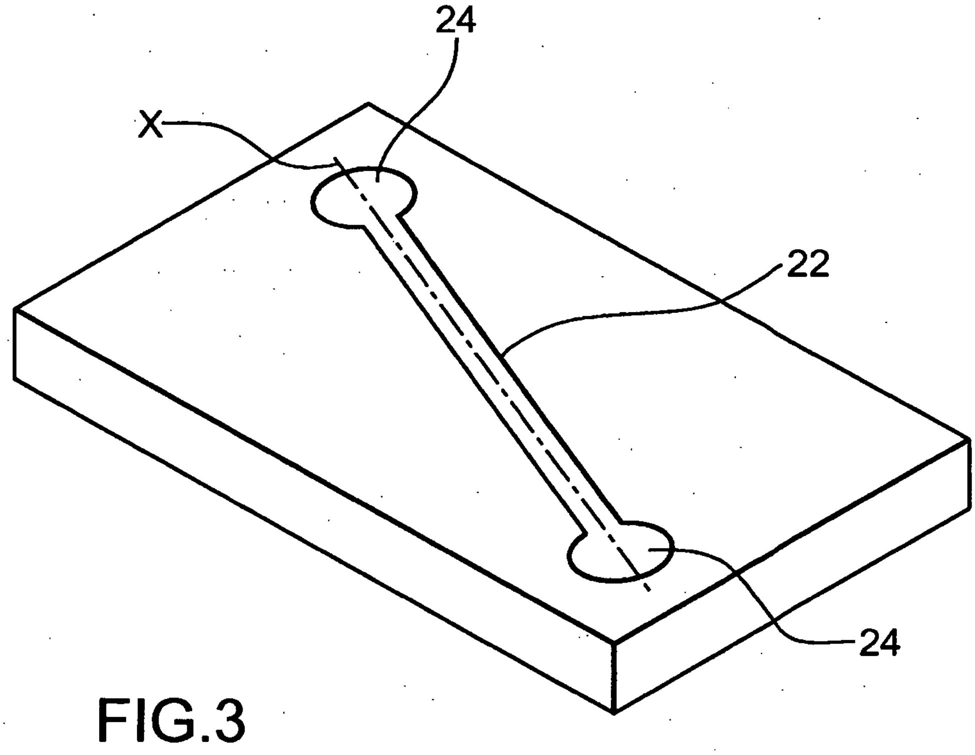


FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 20090035936 A